# EUROPÄISCHE PATENTSCHRIFT

(11) **EP 1 611 616 B1**
(45) Veröffentlichungstag und Bekanntmachung des Hinweises auf die Patenterteilung: **05.05.2010**
(21) Anmeldenummer: 04722857.2
(22) Anmeldetag: 24.03.2004
(51) Int. Cl.: H01L 29/737, H01L 29/08

(54) **BIPOLAR-TRANSISTOR**
BIPOLAR TRANSISTOR
TRANSISTOR BIPOLAIRE

(30) Priorität: 10.04.2003 DE 10316531
(43) Veröffentlichungstag der Anmeldung: 04.01.2006
(73) Patentinhaber: Infineon Technologies AG, 81669 München (DE)
(72) Erfinder: BÖCK, Josef, 81827 München (DE); MEISTER, Thomas, 82024 Taufkirchen (DE); STENGL, Reinhard, 86391 Stadtbergen (DE); SCHÄFER, Herbert, 85635 Höhenkirchen-Siegertsbrunn (DE)
(74) Vertreter: Barth, Stephan Manuel
(86) Internationale Anmeldenummer: PCT/EP2004/003124
(87) Internationale Veröffentlichungsnummer: WO 2004/090989

(56) Entgegenhaltungen:
- JP-A- 2000 216 168
- US-A1- 2002 003 286
- US-A1- 2002 096 742
- US-A1- 2003 042 480
- LAVEANT P ET AL: "Engineering the diffusion behavior of dopants (B,Sb) in silicon by incorporation of carbon" NUCLEAR INSTRUMENTS & METHODS IN PHYSICS RESEARCH, SECTION - B: BEAM INTERACTIONS WITH MATERIALS AND ATOMS, NORTH-HOLLAND PUBLISHING COMPANY. AMSTERDAM, NL, Bd. 186, Nr. 1-4, Januar 2002 (2002-01), Seiten 292-297, XP004330060 ISSN: 0168-583X

## Beschreibung

Die vorliegende Erfindung betrifft einen Bipolar-Transistor.

Obwohl prinzipiell auf beliebige Bipolar-Transistoren anwendbar, werden die vorliegende Erfindung und die ihr zugrundeliegende Problematik in Bezug auf DPSA-Transistoren erläutert.

Die US 2002/0096742 A1 offenbart die Einführung einer Kohlenstoffdotierten Subkollektorschicht zur Reduzierung mechanischer Spannungen und Versetzungen.

Die JP 2000-2162168 A offenbart die Einführung einer Kohlenstoffdotierten Zwischenschicht zwischen Kollektor und Subkollektor zum Gettern von Wasserstoff, der zur Isolation von Transistoren implantiert wird.

DPSA(selbstjustierte Doppel-Polysilizium)-Transistoren sind z.B. aus T.F. Meister et al., IEDM Technical Digest 1995, p.739-741 bekannt.

Ihr Name rührt daher, dass sie als p⁺-Basisanschluss sowie als n⁺-Emitterkontakt zwei eigens hierfür abgeschiedene p⁺-Polysilizium- bzw. n⁺-Polysiliziumschichten verwenden. Dabei ist im Emitterfenster die n⁺-Polysilizium-Emitterschicht selbstjustiert durch einen Spacer von der p⁺-Polysiliziumschicht des Basisanschlusses isoliert. Der DPSA-Transistor kann sowohl eine implantierte Si-Basis als auch eine epitaktisch abgeschiedene SiGe-Basis enthalten. Der Kollektor ist üblicherweise über eine im Substrat vergrabene Buried Layer (auch als Subkollektor bezeichnet) angeschlossen. Aufgrund ihrer lateralen und vertikalen Skalierbarkeit und den geringen parasitären Kapazitäts- und Widerstandsanteilen ist die DPSA-Transistorstruktur für Höchstgeschwindigkeitsanwendungen am besten geeignet.

Um Bipolar-Transistoren für immer höhere Frequenzen tauglich zu machen, müssen parasitäre Kapazitäten und Widerstände verringert und Ladungsträger-Laufzeiten reduziert werden. Kurze Laufzeiten erreicht man bei vertikal aufgebauten Bipolar-Transistoren durch sehr dünne Schichten von Emitter, Basis und Kollektor.

Entscheidend ist also eine möglichst geringe Diffusion der Dotierstoffe, denn die Schichtdicke der Bor dotierten Basis beim npn-Transistor kann nur so klein gewählt werden, dass eine Ausdiffusion des Bors in Nachbarschichten noch keine Nachteile bringt. Dies ist ein Kernproblem beim npn-Bipolar-Transistor, weil Bor neben der normalen Diffusion auch noch eine durch Zwischengitteratome induzierte beschleunigte Diffusion zeigt.

Ähnliche Probleme treten bei einem Phosphor dotierten Kollektor auf, denn auch Phosphor weist eine beschleunigte Diffusion durch Zwischengitteratome auf, was zur Folge hat, dass ein im Kollektor vorhandenes Dotierungsprofil in nicht beabsichtigter Weise verändert werden kann.

Es ist bekannt, dass Zwischengitteratome z.B. durch Oxidation und Implantation entstehen. Insbesondere stellt aber auch die Deaktiverung von Arsen in hochdotierten Schichten (Konzentration von typischerweise 10²⁰cm⁻³), wie z.B. in einer vergrabenen Subkollektorschicht im Bipolar-Transistor, eine Quelle für Zwischengitteratome dar. Siehe dazu P.M. Rouseau et al., Appl. Phys. Lett. 65 (5), 1995, "Electrical deactivation of arsenic as a source of point defects". Da Zwischengitteratome in Silizium hochbeweglich sind, können auch entferntere Quellen eine beschleunigte Bor- oder Phosphordiffusion induzieren und damit ein weiteres Verkleinern der Transistorgeometrie unmöglich machen. Auch ist somit eine Reduzierung des Schichtwiderstandes der vergrabenen Subkollektorschicht durch eine höhere Arsendotierung wegen der Zunahme der störenden Zwischengitteratome nicht sinnvoll.

Die Reduzierung der Konzentration der Zwischengitteratome ist für die weitere Verbesserung der Hochfrequenzeigenschaften von Bipolar-Transistoren also von entscheidender Bedeutung.

Prinzipiell kann die Konzentration der Zwischengitteratome auf zwei Wegen reduziert werden. Einerseits kann das Entstehen von Zwischengitteratomen durch entsprechende Prozessführung verhindert werden, und andererseits können entstandene Zwischengitteratome wieder vernichtet werden.

Das Vernichten entstandener Zwischengitteratome erfolgt beispielsweise durch den Einsatz von mit Kohlenstoff-dotierten Siliziumschichten, welche als Senke für Zwischengitteratome dienen. Dieses Prinzip wird beispielsweise in dem SiGe:C Hetero-Bipolar-Transistor mit Erfolg angewendet, wie z.B. beschrieben in A. Gruhle et al., Appl. Phys. Lett. 75(5), 1999, "The reduction of base dopant outdiffusion in SiGe heterojunction bipolar transistors by carbon doping".

Eine derartige Kohlenstoffdotierung kann dabei üblicherweise in der Basis und/oder im Emitter und/oder im Kollektor angewendet , wie in der WO 98/26457 bzw. der US-2002/0,121,676 A1 offenbart.

Nachteilig bei der bekannten Vorgehensweise ist es, dass der Schutz vor beschleunigter Diffusion nicht vollständig möglich ist und eine Erhöhung der Wirksamkeit durch höhere Kohlenstoffkonzentrationen zwar möglich ist, aber eine Degradation der Transistor-Kennlinien und reduzierte Ladungsträger-Beweglichkeiten mit sich bringt.
Insbesondere ist es nicht möglich, dass Entstehen von Zwischengitteratomen aus einem mit Arsen hochdotierten vergrabenen Subkollektorbereich zu vermeiden, weil in dem entsprechenden Temperaturbereich zwischen 500° C und 900° C viele unverzichtbare Prozessschritte stattfinden.

Als einziger Ausweg blieb bisher also nur eine Verringerung der Arsenkonzentration im vergrabenen Subkollektorbereich, was als Nachteil mit sich bringt, dass der Schichtwiderstand des Subkollektorbereichs vergrößert und dementsprechend die Hochfrequenztauglichkeit des Transistors verschlechtert ist.

Aufgabe der Erfindung ist es, einen verbesserten Bipolar-Transistor anzugeben, wobei eine seitliche Ausdiffusion des Kollektorprofils, z.B. Phosphor, und eine vertikale Ausdiffusion des Basisprofils, z.B. Bor, vermieden werden kann und der gute elektrische Eigenschaften aufweist.

Diese Aufgabe wird durch einen Bipolar-Transistor nach Anspruch 1 gelöst.

Die der vorliegenden Erfindung zugrundeliegende Idee besteht darin, dass die Zwischengitteratome unmittelbar an ihrer Quelle vernichtet werden, indem entweder eine zusätzliche Kohlenstoff-dotierte Siliziumschicht zwischen Subkollektor und Kollektor eingefügt wird oder der Subkollektor selbst mit Kohlenstoff dotiert wird. So lässt sich quasi eine Barriere vorzugsweise im gesamten Verbindungsquerschnitt bilden.

Diese Maßnahme zur Vernichtung der Zwischengitteratome in unmittelbarer Nähe ihres Entstehungsortes kann zusätzlich zu den schon beschriebenen Kohlenstoff-dotierten Schichten für Kollektor, Emitter und Basis erfolgen und den Schutz vor Zwischengitteratomen weiter verbessern.

Ein nachteiliger Effekt auf die Transistorkennlinie ist nicht zu erwarten, da die zusätzliche Kohlenstoff-dotierte Schicht außerhalb der Raumladungszone zwischen Kollektor und Basis liegt. Dadurch kann die Arsenkonzentration im Subkollektorbereich weiter erhöht werden und sein Schichtwiderstand erniedrigt werden, ohne dass Nachteile durch beschleunigte Diffusion von Dotierstoffen im Transistor hingenommen werden müssen.

Bevorzugte Weiterbildungen sind Gegenstand der Unteransprüche.

Gemäss einer bevorzugten Weiterbildung ist der kohlenstoffdotierte Halbleiterbereich der gesamte Subkollektorbereich.

Gemäss einer weiteren bevorzugten Weiterbildung ist der kohlenstoffdotierte Halbleiterbereich ein an den Kollektorbereich direkt oder indirekt angrenzender Teilbereich des Subkollektorbereich.

Gemäss einer weiteren bevorzugten Weiterbildung ist der kohlenstoffdotierte Halbleiterbereich eine zusätzliche Verbindungsschicht zwischen dem Kollektorbereich und dem Subkollektorbereich.

Gemäss einer weiteren bevorzugten Weiterbildung ist der erste Leitungstyp der n-Typ und der zweite Leitungstyp der p-Typ, wobei der Subkollektorbereich Arsen-dotiert ist.

Gemäss einer weiteren bevorzugten Weiterbildung ist der Kollektorbereich Phosphor-dotiert.

Gemäss einer weiteren bevorzugten Weiterbildung ist mindestens einer vom Kollektorbereich, Basisbereich und Emitterbereich kohlenstoffdotiert.

Nachfolgend wird die Erfindung anhand von Ausführungsbeispielen unter Bezugnahme auf die Zeichnungen näher erläutert.

Es zeigen:
- Fig. 1: eine schematische Darstellung einer ersten erfindungsgemässen Ausführungsform eines Bipolar-Transistors;
- Fig. 2: eine schematische Darstellung einer zweiten erfindungsgemässen Ausführungsform eines Bipolar-Transistors;
- Fig. 3: eine schematische Darstellung einer dritten erfindungsgemässen Ausführungsform eines Bipolar-Transistors; und
- Fig. 4: eine schematische Darstellung einer vierten erfindungsgemässen Ausführungsform eines Bipolar-Transistors.

In den Figuren gleiche Bezugszeichen bezeichnen gleiche oder gleich wirkende Elemente.

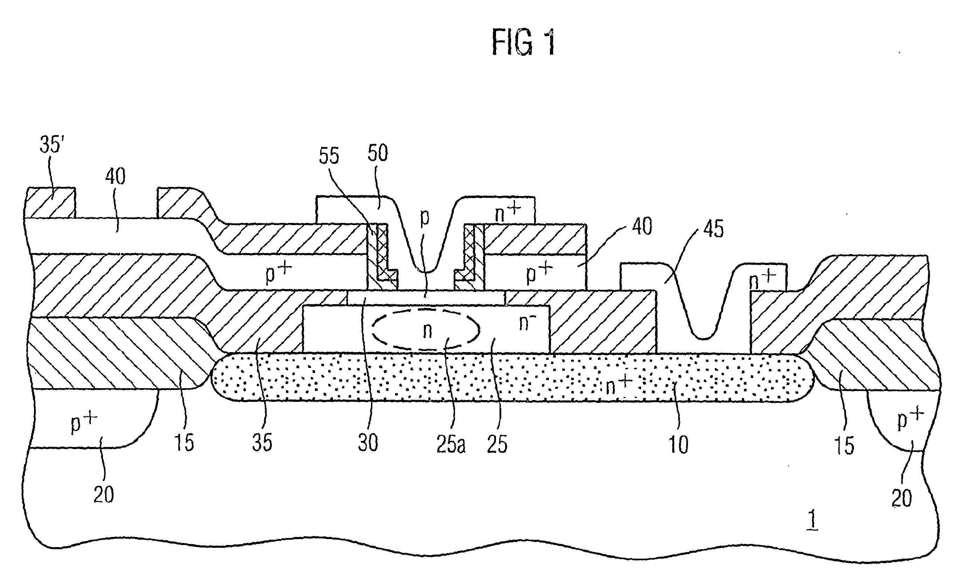

Fig. 1 zeigt eine schematische Darstellung einer ersten erfindungsgemässen Ausführungsform eines Bipolar-Transistors.

In Fig. 1 bezeichnet Bezugszeichen 1 ein Silizium-Halbleitersubstrat, 10 einen Arsen-dotierten n⁺-Subkollektorbereich in Form einer im Substrat 1 vergrabenen Schicht, 20 Bordotierte p⁺-Kanalsperrbereiche, 25 einen Phosphor-dotierten n⁻-Kollektorbereich, 25a einen Phosphor-dotierten n-Kollektorbereich, 30 einen Bor-dotierten p-Basisbereich, 35 sowie 35 eine jeweilige CVD-Isolationsoxidschicht, 15 eine LOCOS-Isolationsoxidschicht, 40 einen p⁺-Basisanschlussbereich, 45 einen n⁺-Kollektorkontakt, 55 einen Doppel-Spacer aus Siliziumoxid/Siliziumnitrid, und 50 einen Phosphor-dotierten n⁺-Emitterbereich.

Der n-Kollektorbereich 25a ist durch eine selbstjustierte Implantation von Phosphor durch das Emitterfenster gegenüber dem umgebenden n⁻-Kollektorbereich 25 aufdotiert und weist dort ein näherungsweise elliptisches Dotierungsprofil (gestrichelte Linie) auf.

Der n⁺-Subkollektorbereich 10 ist vollständig mit Kohlenstoff (C) aufdotiert, wobei typische Werte der C-Konzentration im Berich 10¹⁹ - 10²¹ cm⁻³ liegen. Die Aufdotierung erfolgt hier vorzugsweise durch eine Implantation.

Die unerwünschte Ausdiffusion des n-Kollektorbereichs 25a in den n⁻-Kollektorbereich 25, die zu einer lateralen Verbreiterung des aufdotierten Kollektorbereichs 25a und damit zu einer erhöhten Basis-Kollektor-Kapazität führen würde, lässt sich durch den n⁺-Subkollektorbereich 10, der vollständig mit Kohlenstoff (C) aufdotiert ist, wirkungsvoll verhindern. Ebenso wird eine vertikale Ausdiffusion des Basisprofils verhindert, was zu einer Verbreiterung der Basis und damit zu längeren Laufzeiten der Ladungsträger führen würde.

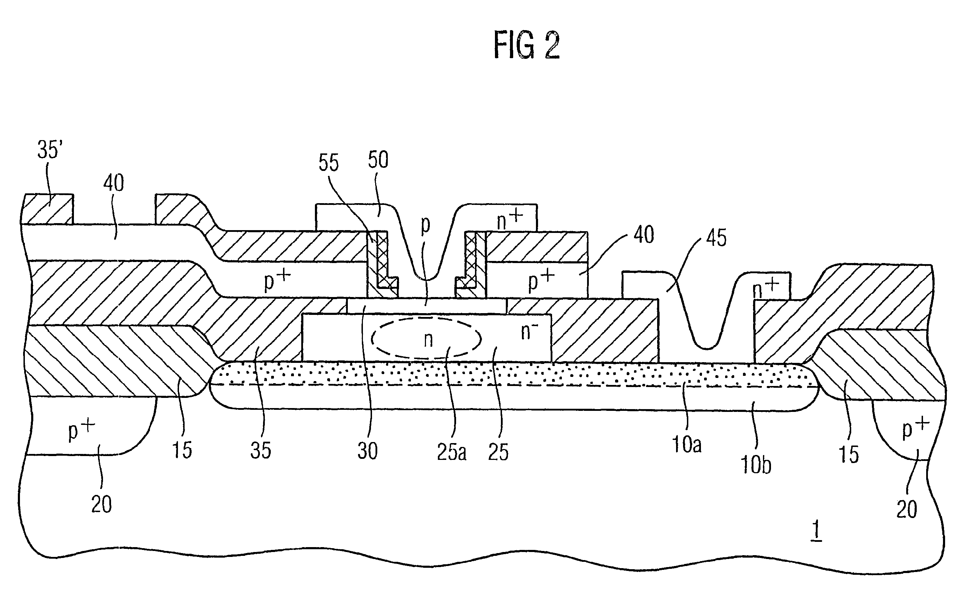

Fig. 2 zeigt eine schematische Darstellung einer zweiten erfindungsgemässen Ausführungsform eines Bipolar-Transistors.

Bei dieser zweiten Ausführungsform ist im Unterschied zur obigen ersten Ausführungsform der kohlenstoffdotierte Halbleiterbereich nur ein an den Kollektorbereich 25, 25a angrenzender Teilbereich 10a des Subkollektorbereich 10a, 10b. Die Aufdotierung erfolgt auch hier vorzugsweise durch eine Implantation.

Der erreichte Effekt ist jedoch gleich wie bei der ersten Ausführungsform.

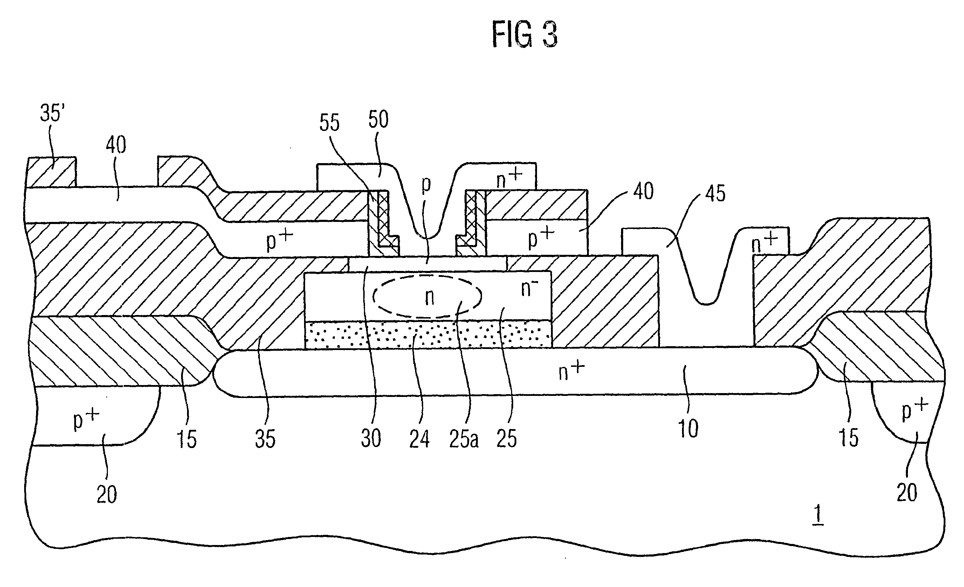

Fig. 3 zeigt eine schematische Darstellung einer dritten erfindungsgemässen Ausführungsform eines Bipolar-Transistors.

Bei dieser dritten Ausführungsform ist im Unterschied zur obigen ersten und zweiten Ausführungsform der kohlenstoffdotierte Halbleiterbereich der kohlenstoffdotierte Halbleiterbereich 24 eine zusätzliche Verbindungsschicht zwischen dem Kollektorbereich 25, 25a und dem Subkollektorbereich 10. Die Aufdotierung kann hier durch eine Implantation nach der Abscheidung der Schicht 24 erfolgen oder in situ während der Abscheidung.

Der erreichte Effekt ist jedoch gleich wie bei der ersten und zweiten Ausführungsform.

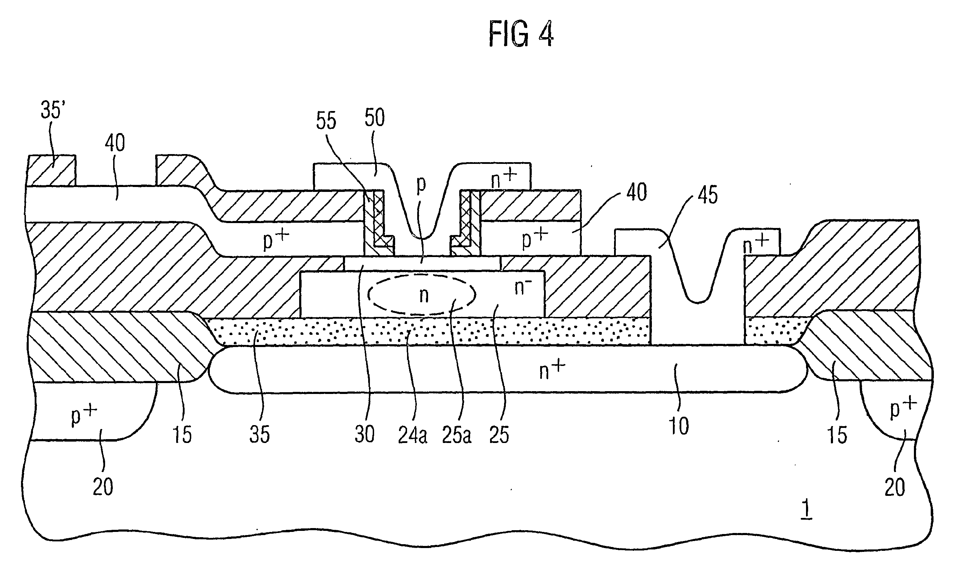

Fig. 4 zeigt eine schematische Darstellung einer vierten erfindungsgemässen Ausführungsform eines Bipolar-Transistors.

Bei dieser vierten Ausführungsform ist im Unterschied zur obigen dritten Ausführungsform der kohlenstoffdotierte Halbleiterbereich 24a nicht nur an der Schnittstelle zum Kollektorbereich 25, 25a vorgesehen, sondern erstreckt sich über den gesamten Subkollektorbereich 10 mit Ausnahme des Kollektorkontakts 45. Die Aufdotierung kann auch hier durch eine Implantation nach der Abscheidung der Schicht 24a erfolgen oder in situ während der Abscheidung.

Der erreichte Effekt ist jedoch gleich wie bei der ersten, zweiten und dritten Ausführungsform.

Die vorliegende Erfindung ist nicht auf die oben erläuterten Ausführungsformen beschränkt, sondern in gleicher Weise bei Homo- und Hetero-Bipolar-Transistoren (insbesondere bei SiGe HBT), bei Trenchisolationen, bei Innen- oder Außenspacer-Konzepten usw. anwendbar. Die Schichtdicke der Kohlenstoff-dotierten Schicht kann zwischen 20 nm bei einer dünnen zusätzlichen Verbindungsschicht und bei ca. 1.000 nm bei einem durchgehend dotierten Subkollektorbereich variieren.

### Bezugszeichenliste

- 1: Silizium-Halbleitersubstrat
- 10,10b: n⁺-Subkollektorbereich
- 20: p⁺-Kanalsperrbereiche
- 10a,24,24a: Kohlenstoff-dotierter Siliziumbereich
- 25: n⁻-Kollektorbereich
- 25a: n-Kollektorbereich
- 30: p-Basisbereich
- 35,35': CVD-Isolationsoxidschichten
- 15: LOCOS-Isolationsoxidschicht
- 40: p⁺-Basisanschlussbereich
- 45: n⁺-Kollektorkontakt
- 55: Doppel-Spacer aus Siliziumoxid/Siliziumnitrid
- 50: n⁺-Emitterbereich

## Patentansprüche

1. Bipolar-Transistor mit:
einem Kollektorbereich (25, 25a) eines ersten Leitungstyps (n);
einem Subkollektorbereich (10; 10a, 10b) des ersten Leitungstyps (n⁺), welcher an einer ersten Seite des Kollektorbereichs (25, 25a) elektrisch an den Kollektorbereich (25, 25a) angeschlossen ist;
einem Basisbereich (30) des zweiten Leitungstyps (p), der an einer zweiten Seite des Kollektorbereichs (25, 25a) vorgesehen ist;
einem Emitterbereich (50) des ersten Leitungstyps (n⁺), der auf der vom Kollektorbereich (25, 25a) abgelegenen Seite über dem Basisbereich (30) vorgesehen ist; und
einem kohlenstoffdotierten Halbleiterbereich (10; 10a; 24, 24a), der auf der ersten Seite neben dem Kollektorbereich (25, 25a) vorgesehen ist;
**dadurch gekennzeichnet,**
**dass** der kohlenstoffdotierte Halbleiterbereich (10; 10a; 24, 24a) eine Kohlenstoffkonzentration von 10¹⁹ - 10²¹ cm⁻³ aufweist;
der Basisbereich (30) einen geringeren Querschnitt als der Kollektorbereich (25, 25a) aufweist und der Kollektorbereich im Überlappungsbereich mit dem Basisbereich (30) einen Bereich (25a) aufweist, der eine gegenüber dem Restbereich (25) des Kollektorbereichs erhöhte Dotierung aufweist; und der kohlenstoffdotierte Halbleiterbereich (10; 10a; 24; 24a) eine Ausdiffusion des Bezirks (25a) des Kollektorbereichs in den Restbereich (25) des Kollektorbereichs verhindert.

2. Bipolar-Transistor nach Anspruch 1,
**dadurch gekennzeichnet,**
**dass** der kohlenstoffdotierte Halbleiterbereich (10; 10a; 24, 24a) der gesamte Subkollektorbereich (10) ist.

3. Bipolar-Transistor nach Anspruch 1,
**dadurch gekennzeichnet,**
**dass** der kohlenstoffdotierte Halbleiterbereich (10; 10a; 24, 24a) ein an den Kollektorbereich (25, 25a) direkt oder indirekt angrenzender Teilbereich (10a) des Subkollektorbereichs (10a; 10b) ist.

4. Bipolar-Transistor nach Anspruch 1,
**dadurch gekennzeichnet,**
**dass** der kohlenstoffdotierte Halbleiterbereich (10; 10a; 24, 24a) eine zusätzliche Verbindungsschicht (24, 24a) zwischen dem Kollektorbereich (25, 25a) und dem Subkollektorbereich (10) ist.

5. Bipolar-Transistor nach einem der vorhergehenden Ansprüche,
**dadurch gekennzeichnet,**
**dass** der erste Leitungstyp (n) der n-Typ ist und der zweite Leitungstyp (p) der p-Typ und der Subkollektorbereich (10; 10a, 10b) Arsen-dotiert ist.

6. Bipolar-Transistor nach Anspruch 7,
**dadurch gekennzeichnet,**
**dass** der Kollektorbereich (25, 25a) Phosphor-dotiert ist.

7. Bipolar-Transistor nach einem der vorhergehenden Ansprüche,
**dadurch gekennzeichnet,**
**dass** mindestens einer vom Kollektorbereich (25, 25a), Basisbereich (30) und Emitterbereich (50) kohlenstoffdotiert ist.

## Claims

1. Bipolar transistor comprising:
a collector region (25, 25a) of a first conduction type (n);
a subcollector region (10; 10a, 10b) of the first conduction type (n⁺), which is electrically connected to the collector region (25, 25a) at a first side of the collector region (25, 25a);
a base region (30) of the second conduction type (p) which is provided at a second side of the collector region (25, 25a);
an emitter region (50) of the first conduction type (n⁺) which is provided above the base region (30) on the side remote from the collector region (25, 25a) and
a carbon-doped semiconductor region (10; 10a; 24, 24a) which is provided on the first side alongside the collector region (25, 25a);
**characterized**
**in that** the carbon-doped semiconductor region (10; 10a; 24, 24a) has a carbon concentration of 10¹⁹ - 10²¹ cm⁻³;
the base region (30) has a smaller cross section than the collector region (25, 25a) and the collector region has, in the overlap region with the base region (30), a region (25a) having an increased doping compared with the remaining region (25) of the collector region; and the carbon-doped semiconductor region (10; 10a; 24; 24a) prevents an outdiffusion from the zone (25a) of the collector region into the remaining region (25) of the collector region.

2. Bipolar transistor according to Claim 1,
**characterized**
**in that** the carbon-doped semiconductor region (10; 10a; 24, 24a) is an entire subcollector region (10).

3. Bipolar transistor according to Claim 1,
**characterized**
**in that** the carbon-doped semiconductor region (10, 10a; 24, 24a) is a partial region (10a) of the subcollector region (10; 10b) that is directly or indirectly adjacent to the collector region (25, 25a).

4. Bipolar transistor according to Claim 1,
**characterized**
**in that** the carbon-doped semiconductor region (10; 10a; 24, 24a) is an additional connecting layer (24, 24a) between the collector region (25, 25a) and the subcollector region (10).

5. Bipolar transistor according to one of the preceding claims,
**characterized**
**in that** the first conduction type (n) is the n-type and the second conduction type (p) is the p-type and the subcollector region (10; 10a, 10b) is arsenic-doped.

6. Bipolar transistor according to Claim 7,
**characterized**
**in that** the collector region (25, 25a) is phosphorus-doped.

7. Bipolar transistor according to one of the preceding claims,
**characterized**
**in that** at least one of the collector region (25, 25a), base region (30) and emitter region (50) is carbon-doped.

## Revendications

1. Transistor bipolaire comprenant :
une zone de collecteur (25, 25a) d'un premier type de conductivité (n) ;
une zone de sous-collecteur (10 ; 10a, 10b) du premier type de conductivité (n⁺), qui est raccordée électriquement à la zone de collecteur (25, 25a) sur un premier côté de la zone de collecteur (25, 25a) ;
une zone de base (30) du second type de conductivité (p), qui est prévue sur un second côté de la zone de collecteur (25, 25a) ;
une zone d'émetteur (50) du premier type de conductivité (n⁺), qui est prévue sur le côté éloigné de la zone de collecteur (25, 25a) au-dessus de la zone de base (30) ; et
une zone de semi-conducteur (10 ; 10a ; 24, 24a) dopée en carbone, qui est prévue sur le premier côté à côté de la zone de collecteur (25, 25a) ;
**caractérisé en ce que** la zone à semi-conducteurs (10 ; 10a ; 24, 24a) dopée en carbone présente une concentration de carbone de 10¹⁹ - 12²¹ cm⁻³ ;
la zone de base (30) présentant une section plus faible que la zone de collecteur (25, 25a) et la zone de collecteur présentant dans la zone de chevauchement avec la zone de base (30) une zone (25a) qui présente un dopage élevé par rapport à la zone résiduelle (25) de la zone de collecteur, et la zone à semi-conducteurs (10 ; 10a ; 24, 24a) dopée en carbone empêche une diffusion de la région (25a) de la zone de collecteur dans la zone résiduelle (25) de la zone de collecteur.

2. Transistor bipolaire selon la revendication 1,
**caractérisé en ce que**
la zone à semi-conducteurs (10 ; 10a ; 24, 24a) dopée de carbone est l'ensemble de la zone de sous-collecteur (10).

3. Transistor bipolaire selon la revendication 1,
**caractérisé en ce que**
la zone à semi-conducteurs (10 ; 10a ; 24, 24a) dopée en carbone est une zone partielle (10a), contiguë directement ou indirectement à la zone de collecteur (25, 25a), de la zone de sous-collecteur (10a ; 10b).

4. Transistor bipolaire selon la revendication 1,
**caractérisé en ce que**
la zone à semi-conducteurs (10 ; 10a ; 24, 24a) dopée en carbone est une couche de liaison (24, 24a) supplémentaire entre la zone de collecteur (25, 25a) et la zone de sous-collecteur (10).

5. Transistor selon l'une quelconque des revendications précédentes,
**caractérisé en ce que**
le premier type de conductivité (n) est le type n et le second type de conductivité (p) est le type p et la zone de sous-collecteur (10 ; 10a ; 10b) est dopée en arsenic.

6. Transistor bipolaire selon la revendication 7,
**caractérisé en ce que**
la zone de collecteur (25, 25a) est dopée en phosphore.

7. Transistor bipolaire selon l'une quelconque des revendications précédentes,
**caractérisé en ce que**
au moins l'une des zones zone de collecteur (25, 25a), zone de base (30) et zone d'émetteur (50) est dopée en carbone.
